# EUROPEAN PATENT SPECIFICATION

(11) **EP 2 532 217 B1**
(45) Date of publication and mention of the grant of the patent: **27.11.2013**
(21) Application number: 11743612.1
(22) Date of filing: 15.04.2011
(51) Int. Cl.: H05K 7/20

(54) **DATA CENTER COOLING**
KÜHLUNG FÜR EIN DATENZENTRUM
REFROIDISSEMENT DE CENTRE DE DONNÉES

(43) Date of publication of application: 12.12.2012
(73) Proprietor: Carrier Corporation, Farmington, Connecticut 06032 (US)
(72) Inventor: GRABON, Michel, 01360 Bressolles (FR); SCHMID, Jacques René, 91450 Soisy-sur-Seine (FR); JOSSERAND, Olivier, 01120 La Boisse (FR); TERRAZ, Gregory, 69003 Lyon (FR)
(74) Representative: Taylor, Adam David
(86) International application number: PCT/IB2011/001426
(87) International publication number: WO 2012/140466

(56) References cited:
- EP-A1- 1 466 234
- JP-A- 2003 166 729
- US-A1- 2008 291 626

## Description

### BACKGROUND

The disclosure relates to data center cooling. More particularly, the disclosure relates to air cooling of data centers having rows of server racks.

WO 2004/051445 A1 discloses a system for cooling a room having a plurality of computer systems housed in racks. A plurality of evaporator units are arranged in series and are configured to receive heated air from the room, cool the air and return the cooled air to the room.

### SUMMARY

One aspect of the disclosure involves a cooling system for cooling an equipment room wherein the equipment is arranged in a plurality of rows (equipment rows) spaced to define a plurality of corridors between respective rows. The cooling system has a plurality of air handling units (AHU) arranged in a plurality of rows (AHU rows). Each AHU row is respectively associated with a respective said equipment row. Each air handling unit has a cooling heat exchanger and a fan positioned to drive an airflow across the cooling heat exchanger from an inlet at one side of the row to an outlet at the other side of the row. A plurality of cooling sources are respectively coupled to the cooling heat exchangers of a respective plurality of the AHUs, each row of AHUs including AHUs coupled to different such cooling sources.

In various implementations, the airflow directions of each of the AHU rows alternate so as to divide the corridors into two groups: a first group along which the inlets of the two adjacent AHU rows draw air; and a second group to which the outlets of the two adjacent AHU rows discharge air. In each AHU row, different AHUs may respectively be coupled to at least three different such cooling sources. More particularly, four different subgroups of the AHUs may respectively be coupled to exactly four different such cooling sources. The AHUs may be coupled to the cooling sources so that each AHU is coupled to a different cooling source than is each immediately adjacent AHU in its own AHU row and each immediately adjacent AHU in the adjacent AHU row(s). The system may further include the equipment and the equipment may comprise singlet rows of server racks. There may be 4-6 said cooling sources. Each cooling source may comprise: a pump for pumping liquid refrigerant to the plurality of air handling units associated with such cooling source; return line returning gaseous refrigerant from the air handling units; and a refrigerant-liquid heat exchanger between the return line and the pump inlet for cooling and liquefying the refrigerant. A plurality of chiller systems delivering chilled liquid to the refrigerant-liquid heat exchangers for liquefying the refrigerant. An additional AHU may have a heat exchanger receiving the chilled liquid from the plurality of chiller systems and may provide room humidity control and/or cooling. The refrigerant may consist in majority in part CO₂ by weight or may consist essentially of CO₂. The details of one or more embodiments are set forth in the accompanying drawings and the description below. Other features, objects, and advantages will be apparent from the description and drawings, and from the claims.

### BRIEF DESCRIPTION OF THE DRAWINGS

FIG. 1 is a partial end view of server racks in an equipment room.
FIG. 2 is a plan view of the server racks in the room.
FIG. 3 is a schematic view of a data center cooling system for the room.
FIG. 4 is a schematic of AHU feed grouping.

Like reference numbers and designations in the various drawings indicate like elements.

### DETAILED DESCRIPTION

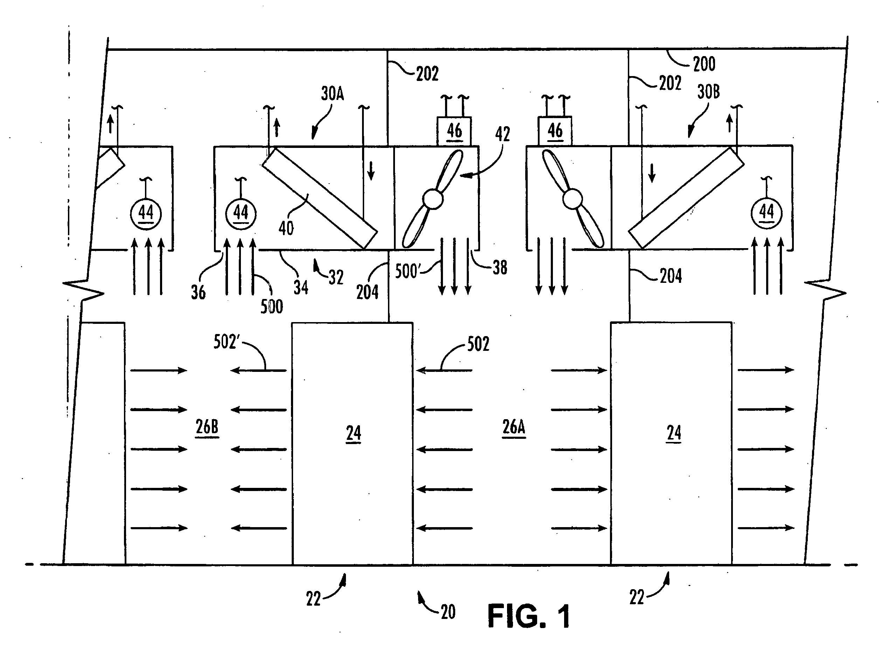

FIG. 1 shows an equipment room 20 containing a plurality of rows 22 of equipment 24 (e.g., computer servers in racks). Between each row is an aisle or corridor 26 (respectively identified as alternating cold corridors 26A and hot corridors 26B discussed below). There is a cooling system 28. Above each row 22 is an associated row 30 (30A and 30B) of air handling units (AHUs) 32 of the system 28. Each air handling unit comprises a housing 34 bounding an air flowpath between an inlet 36 and an outlet 38. An inlet air flow 500 enters the inlet 36 and sequentially passes through a heat exchanger 40 (heat absorption heat exchanger or cooling coil) and a fan 42 (electric motor-driven fan) before being discharged as an outlet air flow 500'. Each AHU may have one or more sensors (e.g., an inlet temperature sensor 44) positioned to measure the temperature of the inlet airflow 500) and a local controller 46 which may be coupled (e.g., hardwired) to the sensors to receive input and to the associated fan 42 to control fan speed. In an exemplary operational method, the controller 46 (e.g., a microcontroller or the like) is pre-programmed with a target inlet temperature or inlet temperature setpoint. With temperature measured by the sensor 44 at this target, the controller 46 may run the fan 42 at a normal default speed. If measured temperature exceeds the target, the controller may increase fan speed proportionally or otherwise corresponding to the difference between measure temperature and set temperature. Similarly, if measured temperature falls below the target, the controller 46 may slow the fan.

The rows of air handling units are divided into two groups 30A and 30B. Viewed in the exemplary orientation, this allows: (a) the inlets of each AHU to be adjacent inlets of the AHU in the row immediately adjacent such inlets; and (b) the outlets to be aligned with the outlets of the AHU in the opposite row (which is adjacent said outlets). This provides the exemplary division of the corridors into cold corridors which receive the outlet flows 500' from the AHUs of both adjacent AHU rows; and hot corridors from which the inlet air flows 500 of both adjacent AHU rows are drawn. This allows air flow 502 to pass through each row 24 from the adjacent cold corridor and exit to the adjacent hot corridor as 502' (e.g., passing through the racks and through the servers in the racks).

In the exemplary system, the AHUs in the rows 30A are identical to those of the rows 30B but oriented in an opposite direction. Alternatively, they may be similarly oriented but the fan motors might be driven oppositely.

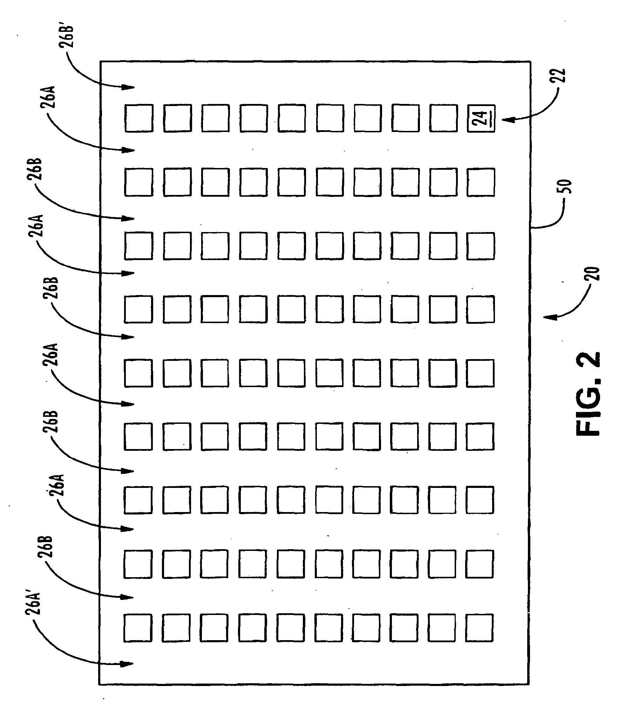

FIG. 2 shows the room 20 defined by a lateral wall 50 (floor and ceiling unnumbered). Common details such as the doors and the normal room climate control system (if any) are not shown. At each end of the array of rows 22, the exemplary configuration includes a corridor along only one side of which are servers. In an exemplary configuration, one end of the array has a cold corridor 26A' and the other end has a hot corridor 26B'. Other configurations are possible. An exemplary number of rows 22 is 4-50, more narrowly, 6-20.

An exemplary number of individual server rack units in each row is at least four, more narrowly, at least six or eight or 10-50. Although FIG. 2 shows a complete array, in many circumstances, the data center will not be filled to capacity and there may be numerous vacancies each with either an empty server rack or no rack at all.

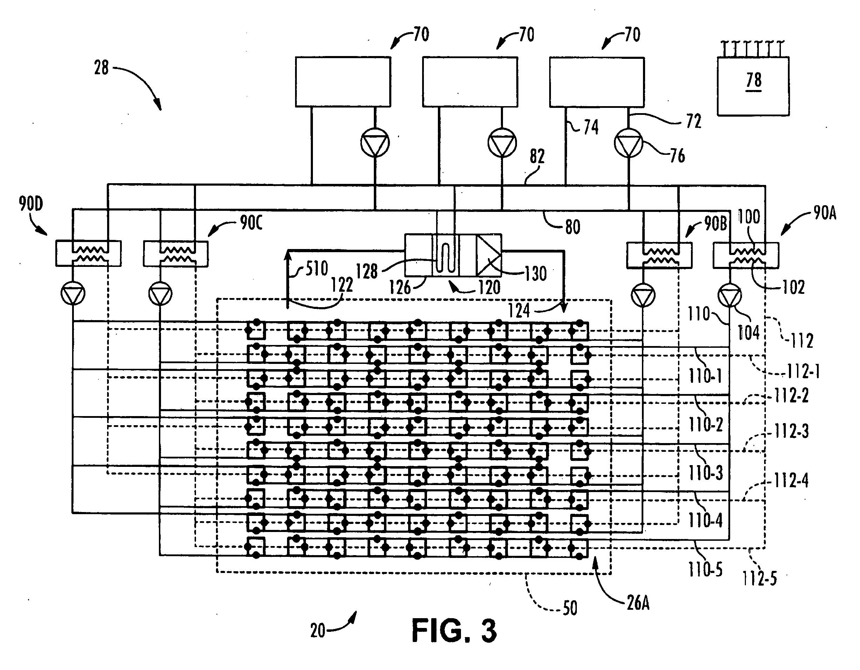

FIG. 3 is a schematic of the cooling system. The exemplary system is shown having an equal number of AHU rows to equipment rows. An exemplary alternative ventilation system may have slightly more or slightly less (e.g., adding AHU rows near the perimeter to provide additional cooling or sacrificing perimeter rows). Additionally, alternative implementations may double up equipment racks in back-to-back rows thereby halving the relative number of AHU rows.

The exemplary implementation shows a like number of air handling units in each row to server racks in each row. However, this may vary with the relative width of the server racks. An exemplary number of AHUs in each row is at least four, more narrowly, at least six or eight or 10-50.

The exemplary AHUs are fed with heat transfer fluid in a multiply redundant way. Exemplary heat transfer fluid is essentially carbon dioxide (e.g., at least 50% by weight) delivered to the heat exchangers 40as a liquid and exiting therefrom as gas.

The exemplary cooling is provided by air-cooled chillers. FIG. 3 shows an exemplary three chillers 70 connected in parallel to provide redundancy. Each chiller 70 comprises an electrically-powered vapor compression system (not shown) to deliver an output flow of chilled water to an associated output/outlet/discharge line 72 and receive a return flow of water through a return line 74. An associated pump 76 may drive the flow. FIG. 3 further shows a system controller 78 which may control overall system operation. The exemplary controller 78 may comprise a microprocessor and memory for executing overall control functions and interfacing either directly with controllable system components or indirectly via local controllers. For example, each of the chillers 70 may have its own local controller, in turn, coupled to the controller 78. By having controllers at different levels of the system and locations, a higher degree of redundancy and failsafe operation can be achieved. The output line and pumps are connected, in common, to a cold water supply line 80 and the lines 74 are connected, in common, to a return line 82.

An additional redundancy is provided by separately feeding individual groups of the AHUs with the heat transfer fluid. In the exemplary implementation, there are plurality of rack units 90 (four shown) each associated with a respective group of the AHUs. Each unit 90 includes a heat exchanger having a first leg 100 receiving chilled water from the supply 80 and returning that water to the return 82. Each heat exchanger has a second leg 102 along a loop of the associated heat transfer fluid (CO₂) to/from the AHUs. The second legs are in heat transfer relation to their associated first legs to reject heat from the CO₂ to the water to condense the CO₂ back to liquid.

Each unit 90 further includes a pump 104 driving the associated flow of heat transfer fluid. Each unit 90 has an outlet/supply line 110 and a return line 112 (shown in broken lines for ease of differentiation). In the exemplary implementation, each of these lines 110, 112 feeds or is fed by a manifold having associated branch lines (110-1, 110-2, 110-3, 110-4, 110-5, 112-1, 112-2, 112-3, 112-4, and 112-5) passing transverse to the AHU rows. Each unit 90 may also have its own controller (not shown) receiving inputs from associated sensors (not shown) and controlling associated controllable equipment including the pump 104.

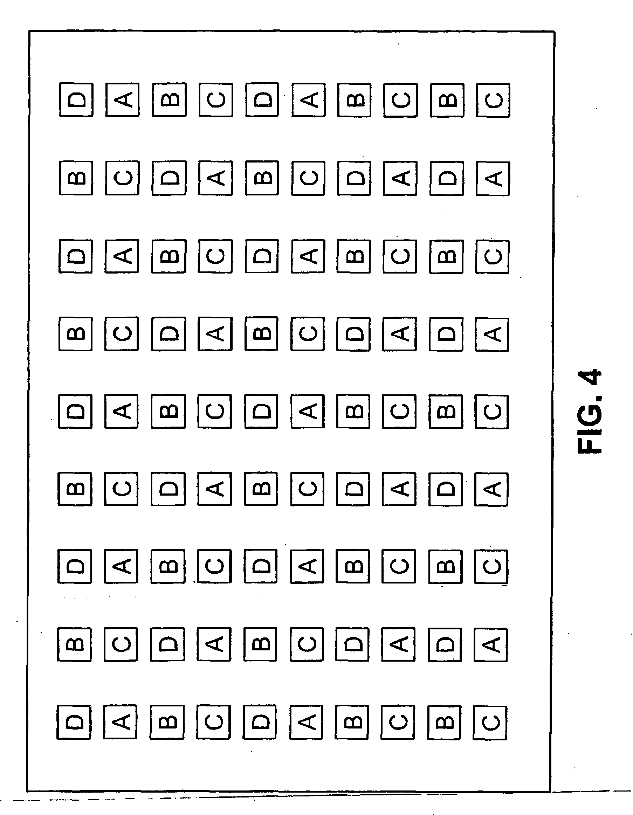

FIG. 3 shows four such units 90A-90D. FIG. 4 shows an exemplary grouping of four groups AHUs by the letters A-D respectively fed by the units 90A-90D. An exemplary number of units is 3-10, more narrowly 4-6.

The AHU heat exchangers 40 are coupled to the associated racks in an alternating fashion such that each AHU is fed from a different rack than are: (a) its one or two immediately adjacent AHUs in the same row; and (b) the immediately adjacent AHUs in the one or two immediately adjacent row(s). Thus, if one rack fails, any server will experience only a slightly diminished air flow because even if the one closest AHU is fed by such rack, the next four most adjacent AHUs would remain unaffected. Even a failure of two racks relatively evenly distributes the lost cooling. Upon failure of one AHU or one of the groups of AHUs, the functioning AHUs near the failed AHUs may help pick up the load. Inlet temperature of the functioning AHUs begins to increase due to the lost adjacent cooling, the controllers 46 will increase fan speed and airflow to increase the cooling provided by the functioning AHUs near any failed AHUs.

Additionally, FIG. 3 further shows a humidity control AHU 120 generally feeding the room by passing an air flow 510 from one or more inlets 122 to one or more outlets 124. The unit 120 includes a housing 126, a heat exchanger 128, and an electric fan 130. The exemplary heat exchanger 128 is a refrigerant-air heat exchanger whose refrigerant leg is coupled to the lines 80 and 82. FIG. 1 also shows means for isolating the hot corridors from the cold corridors. The exemplary means comprises a first set of curtains 202 hanging from the ceiling to the tops of the AHUs and a second set of curtains 204 hanging from the undersides of the AHUs to the tops of the server racks. Walls or other baffles may replace such curtains. Although an embodiment is described above in detail, such description is not intended for limiting the scope of the present invention. It will be understood that various modifications may be made without departing from the scope of the invention, which is defined by the appended claims. For example, when implemented the retrofit of an existing data center, details of the existing data center, and its equipment may influence details of any particular implementation. Accordingly, other embodiments are within the scope of the following claims.

## Claims

1. A cooling system (28) for cooling an equipment room (20) wherein the equipment (24) is arranged in a plurality of rows (22) (equipment rows) spaced to define a plurality of 5 corridors (26) between respective rows, the cooling system comprising:
a plurality of air handling units (AHU) (32) arranged in a plurality of rows (AHU rows) (30), each AHU row respectively associated with and positioned above a respective said equipment row, each air handling unit comprising a cooling heat exchanger (40) and a fan (42) positioned to drive an airflow (500) across the cooling heat exchanger from an inlet (36) to an outlet (38); and
a plurality of cooling sources (90A-D) respectively coupled to the heat exchangers of a respective plurality of the AHUs,
**characterized in that** the inlet (36) is positioned at one side of the AHU row and the outlet (38) is positioned at the other side of the AHU row, and **in that** each row (30) of AHUs includes AHUs (32) coupled to different such cooling sources.

2. The system of claim 1 wherein:
the airflow directions of each of the AHU rows alternate so as to divide the corridors into two groups:
a first group (26B) along which the inlets of the two adjacent AHU rows draw air; and
a second group (26A) to which the outlets of the two adjacent AHU rows discharge air.

3. The system of claim 2 further comprising:
means (202, 204) for isolating each corridor from the adjacent corridor(s).

4. The system of claim 1 wherein:
in each AHU row, different AHUs are respectively coupled to at least three different such cooling sources.

5. The system of claim 1 wherein:
in each AHU row, four different subgroups of the AHUs are respectively coupled to exactly four different such cooling sources.

6. The system of claim 1 wherein:
the AHUs are coupled to the cooling sources so that each AHU is coupled to a different cooling source than is each immediately adjacent AHU in its own AHU row and each immediately adjacent AHU in the adjacent AHU row(s).

7. The system of claim I further comprising:
the equipment and wherein the equipment comprises singlet rows of server racks.

8. The system of claim 1 wherein there are 4-6 said cooling sources.

9. The system of claim I wherein each cooling source comprises:
a pump (104) for pumping liquid refrigerant to the plurality of air handling units associated with such cooling source;
a return line (112) returning gaseous refrigerant from the air handling units; and
a refrigerant-liquid heat exchanger (100,102) between the return line and the pump inlet for cooling and liquefying the refrigerant.

10. The system of claim 9 further comprising:
a plurality of chiller systems (70) delivering chilled liquid to the refrigerant-liquid heat exchangers for liquefying the refrigerant.

11. The system of claim 10 further comprising:
an additional AHU (120) having a heat exchanger (128) receiving the chilled liquid from the plurality of chiller systems (70).

12. The system of claim 10 wherein:
each AHU includes an inlet airflow temperature sensor.

13. The system of claim 10 wherein:
the refrigerant consists essentially of CO₂.

14. A method for operating the system of claim 1 comprising:
running the plurality of cooling sources; and
upon failure of one of the cooling sources, continuing to run the remaining cooling sources, the AHUs associated with the remaining cooling sources at least partially making up for lost cooling capacity of the AHUs associated with the failed cooling source..

15. The method of claim 14 wherein:
the AHUs associated with the remaining cooling sources at least partially make up for lost cooling capacity of the AHUs associated with the failed cooling source via increasing fan speed..

## Patentansprüche

1. Kühlsystem (28) zum Kühlen eines Geräteraums (20), wobei die Geräte (24) in einer Vielzahl von Reihen (22) (Gerätereihen) angeordnet sind, die beabstandet sind, um eine Vielzahl von 5 Durchgängen (26) zwischen den jeweiligen Reihen zu definieren, wobei das Kühlsystem Folgendes umfasst:
eine Vielzahl von Lüftungseinheiten (AHU) (32), die in einer Vielzahl von Reihen (AHU-Reihen) (30) angeordnet sind, wobei jede AHU-Reihe jeweils mit einer jeweiligen Gerätereihe verknüpft und darüber positioniert ist, wobei jede Lüftungseinheit einen Kühl-Wärmetauscher (40) und einen Ventilator (42) umfasst, der positioniert ist, um eine Luftströmung (500) über den Kühl-Wärmetauscher von einem Einlass (36) zu einem Auslass (38) zu treiben; und
eine Vielzahl von Kühlquellen (90A bis D), die jeweils mit den Wärmetauschern einer jeweiligen Vielzahl der AHUs gekoppelt sind,
**dadurch gekennzeichnet, dass** der Einlass (36) auf einer Seite der AHU-Reihe positioniert ist und der Auslass (38) auf der anderen Seite der AHU-Reihe positioniert ist, und dass jede Reihe (30) von AHUs AHUs (32) umfasst, die mit verschiedenen derartigen Kühlquellen gekoppelt sind.

2. System nach Anspruch 1, wobei:
die Luftströmungsrichtungen jeder der AHU-Reihen abwechseln, um die Durchgänge in zwei Gruppen zu unterteilen:
- eine erste Gruppe (26B), an der entlang die Einlässe der beiden angrenzenden AHU-Reihen Luft ansaugen; und
- eine zweite Gruppe (26A), an welche die Auslässe der beiden angrenzenden AHU-Reihen Luft abgeben.

3. System nach Anspruch 2, ferner umfassend:
Mittel (202, 204) zum Isolieren jedes Durchgangs von dem oder den angrenzenden Durchgängen.

4. System nach Anspruch 1, wobei:
in jeder AHU-Reihe verschiedene AHUs jeweils mit mindestens drei verschiedenen derartigen Kühlquellen gekoppelt sind.

5. System nach Anspruch 1, wobei:
in jeder AHU-Reihe vier verschiedene Teilgruppen der AHUs jeweils mit genau vier verschiedenen derartigen Kühlquellen gekoppelt sind.

6. System nach Anspruch 1, wobei
die AHUs mit den Kühlquellen derart gekoppelt sind, dass jede AHU mit einer anderen Kühlquelle gekoppelt ist als jede unmittelbar angrenzende AHU in ihrer eigenen AHU-Reihe und jede unmittelbar angrenzende AHU in der oder den angrenzenden AHU-Reihen.

7. System nach Anspruch 1, ferner umfassend:
die Geräte, und wobei die Geräte Einzelreihen von Server-Rahmen umfassen.

8. System nach Anspruch 1, bei dem es 4 bis 6 Kühlquellen gibt.

9. System nach Anspruch 1, wobei jede Kühlquelle Folgendes umfasst:
eine Pumpe (104) zum Pumpen von flüssigem Kühlmittel zu der Vielzahl von Lüftungseinheiten, die mit derartigen Kühlquellen verknüpft sind;
eine Rückführleitung (112), die gasförmiges Kühlmittel von den Lüftungseinheiten zurückführt; und
einen Kühlmittel/Flüssigkeit-Wärmetauscher (100, 102) zwischen der Rückführleitung und dem Pumpeneinlass zum Kühlen und Verflüssigen des Kühlmittels.

10. System nach Anspruch 9, ferner umfassend:
eine Vielzahl von Kühlersystemen (70), die gekühlte Flüssigkeit an die Kühlmittel/Flüssigkeit-Wärmetauscher zum Verflüssigen des Kühlmittels liefern.

11. System nach Anspruch 10, ferner umfassend:
eine zusätzliche AHU (120), die einen Wärmetauscher (128) aufweist, der die gekühlte Flüssigkeit von der Vielzahl von Kühlersystemen (70) empfängt.

12. System nach Anspruch 10, wobei:
jede AHU einen Einlassluftströmungs-Temperatursensor umfasst.

13. System nach Anspruch 10, wobei:
das Kühlmittel im Wesentlichen aus CO₂ besteht.

14. Verfahren zum Betreiben des Systems nach Anspruch 1, umfassend folgende Schritte:
Betreiben der Vielzahl von Kühlquellen; und
bei einer Störung einer der Kühlquellen, Fortfahren mit dem Betreiben der übrigen Kühlquellen, wobei die AHUs, die mit den übrigen Kühlquellen verknüpft sind, die verlorene Kühlkapazität der AHUs, die mit der fehlerhaften Kühlquelle verknüpft sind, mindestens teilweise kompensieren.

15. Verfahren nach Anspruch 14, wobei:
die AHUs, die mit den übrigen Kühlquellen verknüpft sind, die verlorene Kühlkapazität der AHUs, die mit der fehlerhaften Kühlquelle verknüpft sind, durch Erhöhen der Ventilatorgeschwindigkeit mindestens teilweise kompensieren.

## Revendications

1. Système de refroidissement (28) permettant de refroidir une salle d'équipement (20), dans lequel l'équipement (24) est disposé dans une pluralité de rangées (22) (rangées d'équipement) espacées et définissant un ensemble de 5 couloirs (26) entre les rangées respectives, ce système de refroidissement comprenant :
un ensemble d'unités de traitement d'air (UTA) (32) disposées dans une pluralité de rangées (rangées d'AHU) (30), chaque rangée d'AHU étant respectivement associée à une rangée respective d'équipement et positionnée au-dessus d'elle, chaque unité de traitement d'air comprenant un échangeur de chaleur de refroidissement (40) et un ventilateur (42) positionnés pour entraîner un flux d'air (500) à travers l'échangeur de chaleur de refroidissement à partir d'une entrée (36) jusqu'à une sortie (38) ; et
une pluralité de sources de refroidissement (90 A à D), respectivement couplées aux échangeurs de chaleur d'une pluralité respective des AHU,
**caractérisé en ce que** l'entrée (36) est positionnée d'un côté de la rangée d'AHU et **en ce que** la sortie (38) est positionnée de l'autre côté de la rangée d'AHU, et **en ce que** chaque rangée (30) d'AHU comprend des AHU (32) couplées à différentes sources de refroidissement.

2. Système selon la revendication 1, dans lequel :
les directions de flux d'air de chacune des rangées d'AHU alternent de manière à diviser les couloirs en deux groupes :
un premier groupe (26B) le long duquel les entrées des deux rangées adjacentes d'AHU aspirent de l'air ; et
un deuxième groupe (26A) au niveau duquel les sorties des deux rangées adjacentes d'AHU évacuent de l'air.

3. Système selon la revendication 2, comprenant en outre :
des moyens (202, 204) permettant d'isoler chaque couloir du ou des couloirs adjacents.

4. Système selon la revendication 1, dans lequel :
dans chaque rangée d'AHU, différentes AHU sont respectivement couplées à au moins trois sources différentes de refroidissement.

5. Système selon la revendication 1, dans lequel :
dans chaque rangée d'AHU, quatre sous-groupes différents des AHU sont respectivement couplés à exactement quatre sources différentes de refroidissement.

6. Système selon la revendication 1, dans lequel :
les AHU sont couplées aux sources de refroidissement de sorte que chaque AHU est couplée à une source différente de refroidissement que celle qui, dans chaque cas, est immédiatement adjacente dans sa propre rangée d'AHU et que celle qui, dans chaque cas, est immédiatement adjacente dans la ou dans les rangée(s) adjacente(s) d'AHU.

7. Système selon la revendication 1, comprenant en outre :
l'équipement, et dans lequel l'équipement comprend des rangées simples de tiroirs de serveur.

8. Système selon la revendication 1, dans lequel il existe 4 à 6 sources de refroidissement.

9. Système selon la revendication 1, dans lequel chaque source de refroidissement comprend :
une pompe (104) permettant de pomper un réfrigérant liquide vers la pluralité d'unités de traitement d'air associée à cette source de refroidissement ;
une conduite de retour (112) qui renvoie du réfrigérant gazeux à partir des unités de traitement d'air ; et
un échangeur de chaleur réfrigérant-liquide (100, 102) entre la conduite de retour et l'entrée de la pompe, pour refroidir et pour liquéfier le réfrigérant.

10. Système selon la revendication 9, comprenant en outre :
un ensemble de systèmes de réfrigération (70) alimentant en liquide réfrigéré les échangeurs de chaleur réfrigérant-liquide, afin de liquéfier le réfrigérant.

11. Système selon la revendication 10, comprenant en outre :
une AHU supplémentaire (120) comportant un échangeur de chaleur (128) recevant le liquide réfrigéré à partir de l'ensemble de systèmes de réfrigération (70).

12. Système selon la revendication 10, dans lequel :
chaque AHU comprend un capteur de température de flux d'air d'entrée.

13. Système selon la revendication 10, dans lequel :
le réfrigérant est surtout constitué de CO₂.

14. Procédé d'actionnement du système de la revendication 1, comprenant :
l'actionnement de l'ensemble des sources de refroidissement ; et
en cas de défaillance de l'une des sources de refroidissement, la poursuite de l'actionnement des autres sources de refroidissement, les AHU associées aux autres sources de refroidissement compensant au moins en partie la perte de capacité de refroidissement des AHU associées à la source défaillante de refroidissement.

15. Procédé selon la revendication 14, dans lequel :
les AHU associées aux autres sources de refroidissement compensent au moins en partie la perte de capacité de refroidissement des AHU associées à la source défaillante de refroidissement par une augmentation de la vitesse du ventilateur.
